# FASCICULE DE BREVET EUROPEEN

(11) **EP 1 633 042 B1**
(45) Date de publication et mention de la délivrance du brevet: **05.05.2010**
(21) Numéro de dépôt: 04104267.2
(22) Date de dépôt: 03.09.2004
(51) Int. Cl.: H03H 9/21

(54) **Résonateur à quartz de très petites dimensions**
Quartzresonator mit sehr kleinen Abmessungen
Quartz resonator of very small dimensions

(43) Date de publication de la demande: 08.03.2006
(73) Titulaire: ETA SA Manufacture Horlogère Suisse, 2540 Grenchen (CH)
(72) Inventeur: Dalla Piazza, Silvio, 2610 Saint-Imier (CH); Studer, Bruno, 4533 Riedholz (CH); Lüthi, Thomas, 2540 Grenchen (CH)
(74) Mandataire: Ravenel, Thierry Gérard Louis

(56) Documents cités:
- FR-A- 2 467 487
- JP-A- 2004 200 914
- US-A1- 2002 089 386
- PATENT ABSTRACTS OF JAPAN vol. 002, no. 096 (E-048), 11 août 1978 (1978-08-11) & JP 53 060594 A (SEIKO EPSON CORP), 31 mai 1978 (1978-05-31)
- PATENT ABSTRACTS OF JAPAN vol. 007, no. 154 (E-185), 6 juillet 1983 (1983-07-06) & JP 58 062917 A (DAINI SEIKOSHA KK), 14 avril 1983 (1983-04-14)
- PATENT ABSTRACTS OF JAPAN vol. 005, no. 040 (E-049), 17 mars 1981 (1981-03-17) & JP 55 162612 A (CITIZEN WATCH CO LTD), 18 décembre 1980 (1980-12-18)

## Description

### DOMAINE TECHNIQUE

La présente invention concerne, de manière générale, les résonateurs piézo-électriques et plus particulièrement, des résonateurs de très petites dimensions qui sont utilisés le plus souvent pour la réalisation de générateurs de fréquences, notamment pour des équipements électroniques portables, dans de nombreux domaines comme l'horlogerie, l'informatique, les télécommunications et la médecine.

### ARRIÈRE-PLAN TECHNOLOGIQUE

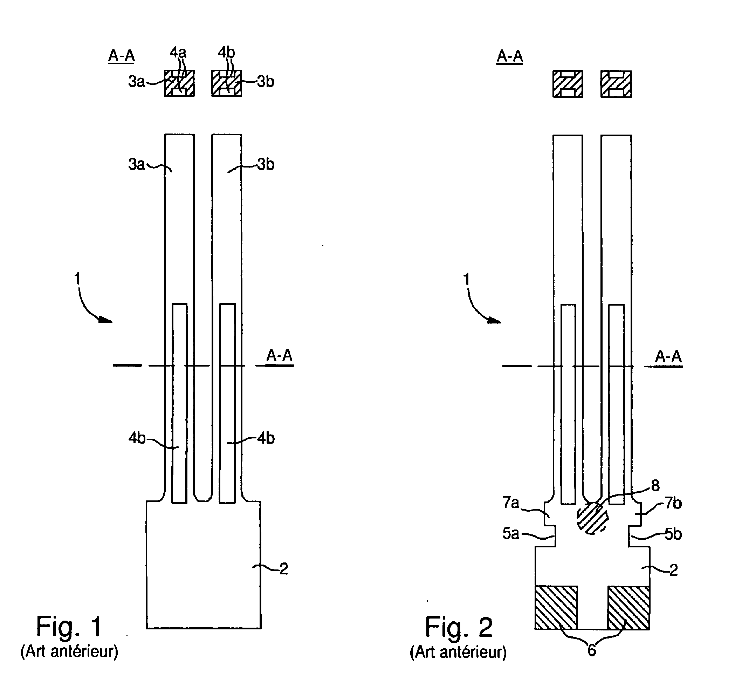

Il est connu des résonateurs piézo-électriques à diapason dans lesquels le champ électrique d'excitation est créé dans une direction parallèle à l'une de leurs faces par des électrodes dont certaines sont disposées sur cette face. Un tel résonateur à diapason 1, représenté sur la figure 1, comprend une base 2 et deux bras vibrants 3a et 3b s'étendant depuis la base. Dans le but, de diminuer la consommation d'énergie grâce à une excitation par un champ électrique plus homogène, il est connu, notamment du document FR 2 467 487, de prévoir sur chacun des bras au moins une rainure 4a et 4b sur les faces inférieure et/ou supérieure, de telle sorte que les bras présentent généralement une section en forme de H, comme cela est visible sur la coupe A-A de la figure 1.

De tels résonateurs piézo-électriques bien que de petites dimensions, de l'ordre du millimètre, présente encore un encombrement trop important au vu des besoins toujours plus grand dans la miniaturisation des équipements électroniques, tels des téléphones portables ou des montres.

Une solution préconisée dans l'art antérieur, représentée à la figure 2 et décrite plus en détail dans le document US No. 6,587,009, consiste à pourvoir sur les flancs de la base 2 du résonateur piézo-électrique des encoches 5a et 5b. Ces encoches 5a et 5b ont principalement pour but de découpler mécaniquement la zone 6 de la base 2 servant à fixer le résonateur 1 dans son boîtier (non représenté), des bras vibrants 3a et 3b. Les encoches 5a et 5b permettent plus particulièrement de découpler les vibrations, qui génèrent un mouvement dans la zone des épaules 7a et 7b. Ce découplage mécanique entre la zone 6 de fixation de la base et les bras vibrants 3a et 3b permet de réduire le rapport de taille entre la base 2 et les bras 3a et 3b et donc de réduire la taille totale du résonateur 1 sans en modifier le mode de fonctionnement.

Toutefois une telle solution présente certains inconvénients. L'analyse de cette solution antérieure a montré que ces encoches 5a et 5b ne permettent de découpler le diapason des stress thermiques engendré par le non-accord des coefficients thermiques, résultant ainsi en la propagation d'un stress mécanique statique dans une zone médiane 8 de la base 2 située entre les deux bras 3a et 3b. De plus, le stress élastique dynamique est maximum dans cette zone médiane 8. Cette combinaison du stress mécanique statique variant avec la température et du stress élastique dynamique, a pour conséquence d'altérer les caractéristiques du résonateur 1.

Une solution pour améliorer la résistance du résonateur à ces types de stress est l'utilisation d'un agent adhésif souple, comme par exemple des colles silicones conductrices, pour le montage du résonateur dans son boîtier. Néanmoins, de tels agents adhésifs souples présentent des problèmes d'adhérence et de résistance aux chocs, une telle solution n'est donc pas souhaitable.

De plus, les encoches 5a et 5b affaiblissent la structure mécanique du résonateur 1 ce qui pose problème en cas de chocs, et plus particulièrement en cas de chocs latéraux. En effet, lors d'un choc latéral, les forces exercées sur l'ensemble du résonateur 1, c'est-à-dire sur les bras 3a et 3b et sur la base 2, résultent en un stress maximum au point d'intersection entre chaque encoche 5a et 5b et la zone 6 de fixation de la base.

Il est également connu du document JP 2004-200914, un résonateur pourvu d'un trou au travers de sa base et de rainures sur ses bras vibrants.

L'un des buts principaux de la présente invention est de pallier aux inconvénients susmentionnés en réalisant un résonateur piézo-électrique présentant, d'une part, une taille réduite ainsi qu'une consommation en énergie également réduite et, d'autre part, une bonne résistance aux différents stress que peut subir le résonateur, ainsi qu'une bonne résistance aux chocs.

### RÉSUMÉ DE L'INVENTION

Dans le cadre de la présente invention, il a été mis en évidence que le remplacement des encoches formées dans la base par un trou pratiqué entre la zone de fixation du résonateur et les bras vibrants permet, notamment, de découpler parfaitement les stress thermiques statiques de la zone médiane de la base située entre les bras, et ainsi de ne pas avoir de couplage dans la zone de stress élastique dynamique. Ce trou permet également d'allonger artificiellement la longueur effective des bras, permettant ainsi, de réduire la taille totale du résonateur pour une même fréquence de résonance. De plus, la résistance aux chocs latéraux se trouve renforcée, car le résonateur ne présente plus de point de faiblesse au voisinage de la zone de fixation, tout en préservant la même résistance qu'une solution avec encoches dans la direction perpendiculaire au plan du résonateur.

Ainsi selon un mode de réalisation préféré de l'invention, le résonateur comprend une base formée d'une première zone de fixation, d'une deuxième zone centrale de découplage mécanique et d'une troisième zone, opposée à la première zone de fixation, troisième zone à partir de laquelle s'étendent au moins deux bras vibrants, sur chacun desquels au moins une rainure est formée sur au moins une des faces supérieure ou inférieure des bras, la base étant pourvue d'un trou au travers de la deuxième zone centrale de découplage mécanique caractérisé en ce que ledit trou présente une forme polygonale dont au moins deux côtés adjacents forment un angle de 60 ou 120° du côté des flancs latéraux de la base.

Ce type de résonateur est généralement destiné à être conditionné dans un boîtier. Grâce aux avantages procurés par l'utilisation d'un trou à la place des encoches, il est possible d'améliorer encore la résistance aux chocs en sélectionnant une fixation rigide, comme par exemple une colle conductrice epoxy, pour fixer le résonateur à son boîtier.

On notera encore, toujours dans l'optique d'améliorer la résistance du résonateur, qu'avantageusement le trou présente une forme polygonale dont les côtés sont découpés de manière à minimiser la révélation des plans cristallins du résonateur piézo-électrique.

Enfin, la présente invention concerne également un vibrateur comprenant un boîtier dans lequel est fixé rigidement un résonateur piézo-électrique selon l'un des modes de réalisation de l'invention.

### BRÈVE DESCRIPTION DES DESSINS

D'autres caractéristiques et avantages de la présente invention apparaîtront plus clairement à la lecture de la description détaillée qui suit de modes de réalisation de l'invention donnés uniquement à titre d'exemple non limitatif et illustrés par les dessins annexés où :
- la figure 1, déjà décrite, représente un résonateur piézo-électrique à diapason présentant des rainures sur ses bras, selon un art antérieur;
- la figure 2, déjà décrite, représente un résonateur piézo-électrique à diapason présentant des rainures sur ses bras et des encoches sur sa base, selon un autre art antérieur;
- les figures 3A et 3B représentent un résonateur piézo-électrique à diapason présentant des rainures sur ses bras et un trou dans sa base, selon deux variantes d'un premier mode de réalisation de l'invention;
- les figures 4A et 4B représentent un résonateur piézo-électrique à diapason selon deux autres variantes du premier mode de réalisation de l'invention;
- les figures 5A-5D représentent un résonateur piézo-électrique à diapason selon d'autres modes de réalisation de l'invention;
- la figure 6A représente une vue de dessus du résonateur montrant un exemple de disposition des électrodes;
- la figure 6B représente une vue en coupe de la figure 7A selon une coupe effectuée au niveau des rainures;
- la figure 7 représente un vibrateur comprenant un résonateur selon l'un quelconque des modes de réalisation de l'invention.

### DESCRIPTION DE MODES DE RÉALISATION PRÉFÉRÉS

Comme cela a été mentionné précédemment, la présente invention concerne un résonateur piézo-électrique présentant, d'une part, une consommation réduite grâce à une excitation par un champ électrique plus homogène et, d'autre part, un bon découplage mécanique entre la base et les bras du résonateur ainsi qu'une plus grande résistance aux chocs, en particulier latéraux.

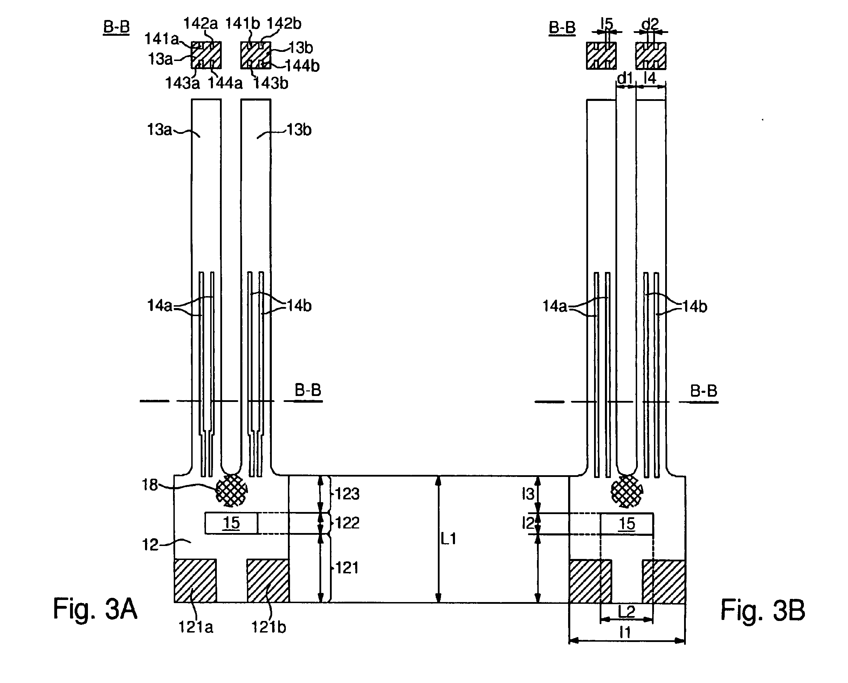

Les figures 3A et 3B représentent un résonateur piézo-électrique à diapason selon deux variantes d'un premier mode de réalisation de l'invention. Le résonateur 10 comprend une base 12 depuis laquelle s'étendent deux bras vibrants 13a et 13b présentant chacun au moins une rainure 14a, 14b sur au moins une des faces supérieure et / ou inférieure des bras. Sur l'exemple représenté, selon la coupe B-B, chacun des bras 13a et 13b comprend avantageusement deux rainures (141a-144a, 141b, 144b) sur chacune des faces supérieure et inférieure.

L'utilisation de deux petites rainures permet d'optimiser le couplage piézo-électrique en maximisant la capacité dynamique du résonateur tout en affaiblissant au minimum la section des bras.

Dans le but d'avoir une structure mécanique des bras la plus résistante possible, il est prévu selon une première variante, représentée à la figure 3A, que les rainures d'un même bras disposées sur une même face présente entre elles un écartement réduit dans la zone des bras proche de la base 12 du résonateur.

Selon une deuxième variante plus simple et présentant une résistance des bras satisfaisante, représentée à la figure 3B, que les rainures d'un même bras sur une même face présente entre elles un écartement constant jusqu'au niveau de la base 12 du résonateur, ce qui a pour effet de maximiser l'effet désiré sur la capacité dynamique.

A titre de variantes additionnelles, on notera qu'il est également possible de n'avoir qu'une rainure sur une face ou les deux faces de chacun des bras. Néanmoins, dans ce cas, l'écartement entre les rainures au niveau de la base devra préférentiellement être rétréci, si l'on veut éviter de trop affaiblir la structure mécanique des bras.

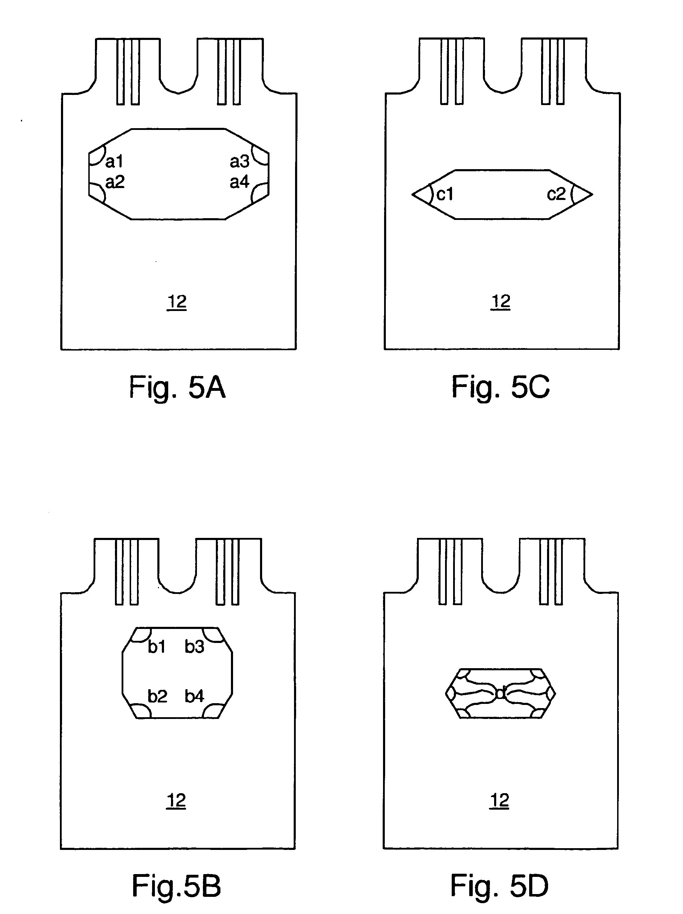

En considérant toujours les figures 3A et 3B, la base 12 est décomposée en trois zones. Une première zone 121 dite de fixation, qui sert à fixer le résonateur 10 à un boîtier (non représenté ici) dans lequel le résonateur est conditionné. Les zones hachurées 121a et 121b, sur lesquelles sont appliquées soit des points de colle, soit des points de soudure, représentent un exemple d'utilisation de la zone de fixation 121 pour fixer le résonateur 10 à son boîtier. Une deuxième zone 122 centrale comprend un trou 15 assurant d'une part un découplage des stress thermiques statiques de la zone médiane 18 de la base située entre les bras, et ainsi de ne pas avoir de couplage dans la zone de stress élastique dynamique. Ce trou 15 permet également d'allonger artificiellement la longueur effective des bras 13a et 13b, permettant ainsi, de réduire la taille totale du résonateur 10 pour une même fréquence de résonance. De plus, la résistance aux chocs latéraux se trouve renforcée, car le résonateur 10 ne présente pas de point de faiblesse sur les faces latérales de la base 12, tout en préservant la même résistance dans la direction perpendiculaire au plan du résonateur 10. Enfin, une troisième zone 123 assure une zone minimum de matière entre le trou 15 de la zone centrale 122 et les bras vibrants 13a et 13b. On notera que le trou présente une forme rectangulaire selon l'exemple représenté. Toutefois, ce dernier peut également avoir une forme de carré ou encore d'autres formes avantageuses, dont certaines sont détaillées en relation avec les figures 5A-5D.

De tels résonateurs sont de très petites dimensions. Dans le cadre de la présente invention, il a été mis en évidence certains rapports de dimension avantageux. Les dimensions suivantes sont données à titre d'exemple.

| | | |
|---|---|---|
| Longueur de la base | L1 | : 610 µm |
| Largeur de la base | I1 | : 552 µm |
| Longueur du trou | L2 | : 220 µm |
| Largeur du trou | I2 | : 102 µm |
| Largeur de la 3^{ème} zone | I3 | : 156 µm |
| Largeur d'un bras | I4 | : 144 µm |

Ainsi, le résonateur présente de préférence les rapports de dimensions suivants:
- le rapport de la largeur du trou l2 sur la longueur de la base L1 est compris entre 10 et 50%, et avantageusement entre 15 et 25%;
- le rapport de longueur du trou L2 sur la largeur de la base l1 est compris entre 33 et 75%, et avantageusement entre 39 et 50%;
- le rapport de la largeur de la 3^{ème} zone sur la largeur d'un bras est compris entre 50 et 200%, et avantageusement entre 80 et 130%.

Comme mentionné précédemment, l'utilisation de deux rainures présentant entre elles un écartement constant (figure 3B), a pour effet de maximiser l'effet désiré sur la capacité dynamique. A titre d'exemple, les dimensions suivantes peuvent être utilisées pour les rainures :

| | | |
|---|---|---|
| Distance entre les bras | d1 | : 92 µm |
| Largueur des rainures | I5 | : 20 µm |
| Ecartement entre les rainures | d2 | : 34 µm |

Avantageusement, le rapport de la largeur d'une rainure l5 sur la largeur d'un bras 14 est compris entre 10 et 30%, et le rapport de la distance entre les rainures d2 sur la largeur d'un bras l4 est compris entre 20 et 30%.

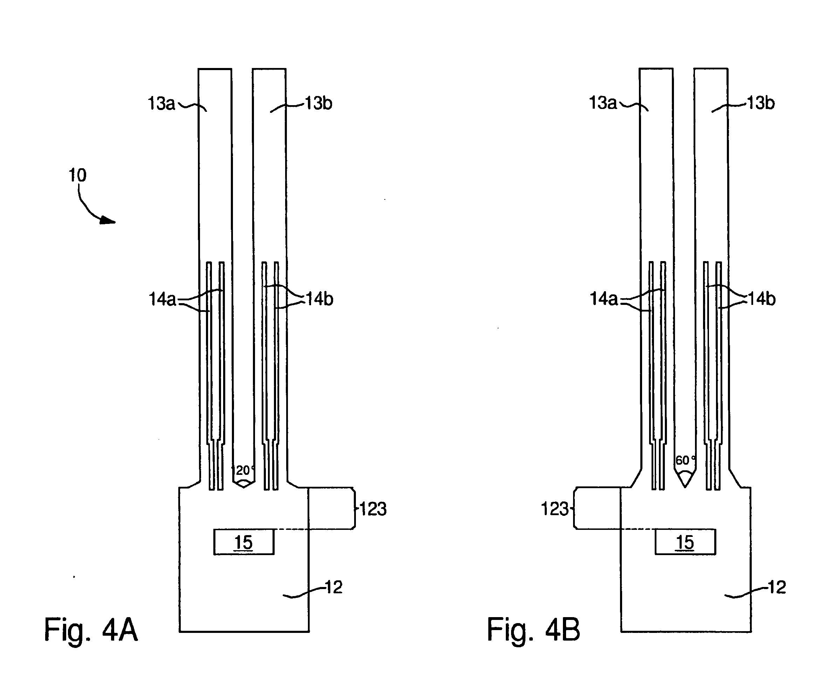

Les figures 4A et 4B représentent un résonateur piézo-électrique à diapason selon des troisième et quatrième variantes du premier mode de réalisation. Les éléments communs avec les figures 3A et 3B sont désignés avec les mêmes références numériques.

Dans le but d'améliorer encore la résistance aux chocs du résonateur 10, il est prévu que la troisième zone 123 de la base 12 présente au niveau de la fixation des bras 13a et 13b une découpe minimisant la révélation des plans cristallins du résonateur piézo-électrique. Dans l'exemple d'un résonateur à quartz, la découpe forme des angles d'environ 60° (figure 4A) ou 120° (figure 4B). Ces plans à 60° ou 120° correspondent aux directions cristallines équivalentes du quartz, ce qui permet de minimiser les résidus d'attaque provenant de l'attaque chimique anisotrope du quartz. Il est en effet bien connu que ces résidus d'attaque, qui révèlent les intersections de plans cristallins, sont des points faibles en cas de chocs.

Ces deux variantes ont été représentées avec des rainures 14a et 14b présentant un écartement constant. Cependant, il est bien entendu que toutes les variantes sur les différentes structures de rainures utilisables présentées en relation avec les figures 3A et 3B sont adaptables ici.

Les figures 5A-5D représentent uniquement les bases 12 de résonateur piézo-électrique selon d'autres modes de réalisation de l'invention concernant en particulier la géométrie du trou 15 pratiqué dans la base du résonateur 10. De la même manière que pour la zone située au niveau de la fixation des bras à la base du résonateur, il est intéressant d'utiliser un trou de forme polygonale, dont au moins deux côtés forment un angle minimisant la révélation des plans cristallins lors de l'attaque. Dans l'exemple d'un cristal de quartz, les polygones ont au moins deux côtés formant un angle de 60° ou 120°.

La figure 5A représente un trou de forme octogonale présentant 4 angles (a1-a4) de 120°, avantageusement, du côté des flancs latéraux de la base 12 du résonateur, permettant ainsi de renforcer la résistance aux chocs latéraux. La figure 5B représente une variante de trou de forme octogonale.

La figure 5C représente un trou de forme hexagonale présentant 2 angles (c1-c2) de 60° du coté des flancs latéraux de la base 12 du résonateur. La figure 5D représente une variante avantageuse de trou de forme hexagonale présentant 6 angles (d1-d6) de 120°.

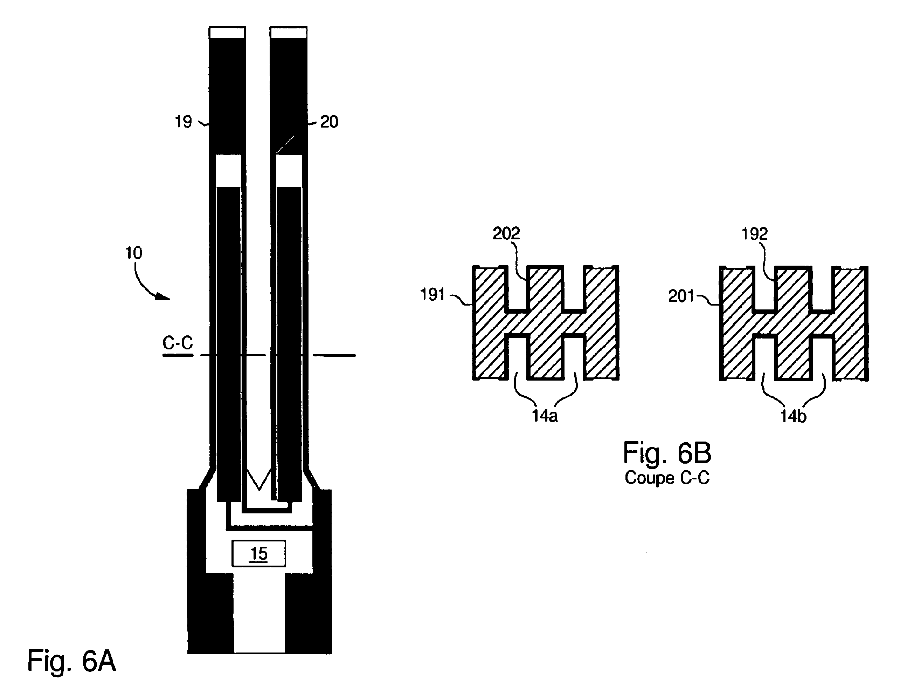

La figure 6A représente une vue de dessus d'un exemple de disposition des électrodes 19 et 20 utilisées pour exciter électriquement le résonateur 10. Ces électrodes 19 et 20 sont obtenues par des procédés classiques, comme par exemple celui décrit dans le document US No. 6,587,009 en liaison avec les figures 14 à 17.

La figure 6b représente une vue agrandie selon la coupe C-C de la figure 6A. Cette vue permet de montrer l'avantage procuré par l'utilisation de rainures. En effet, la présence des rainures (141a-144a, 141b-144b) favorise la création d'un champ électrique homogène selon l'axe X du cristal. Leur rôle est illustré par les lignes de force du champ créé en fonctionnement qui ont été représentées sur la section d'un bras du résonateur. Dans cet exemple du bras de résonateur comprend 2 rainures sur chacune des faces inférieures et supérieures. Au niveau des rainures, la partie latérale 191, respectivement 201 des électrodes est formée principalement sur la tranche du résonateur ainsi que sur une fine bande sur les faces supérieures et inférieures. La partie centrale 192, respectivement 202 des électrodes est constituée par exemple par un dépôt d'or, recouvrant les deux rainures d'une même face ainsi que de la zone pleine entre ces deux rainures. Les électrodes de même pôle de la source d'alimentation sont connectées ensemble par le biais de pistes conductrices non représentées.

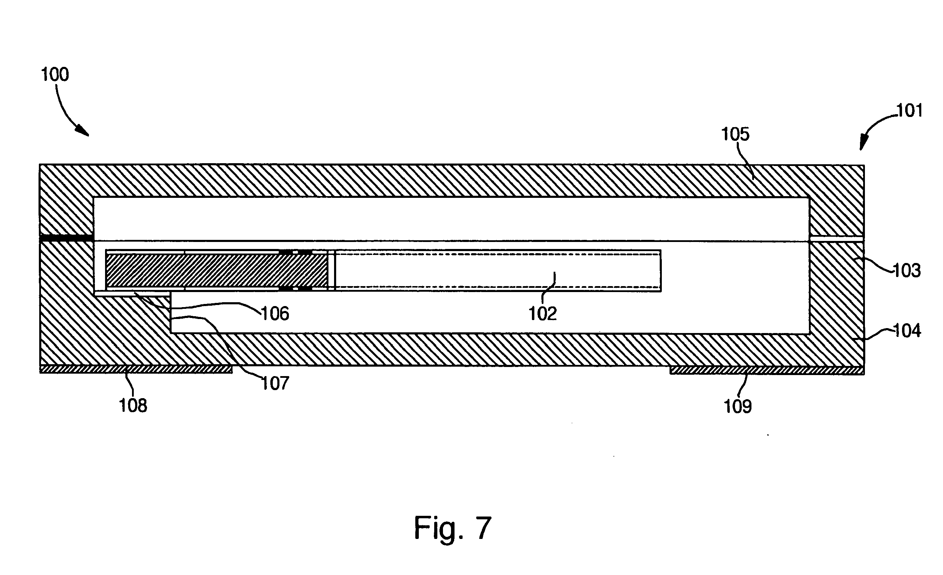

La figure 7 représente un vibrateur 100 comprenant un résonateur piézo-électrique selon l'un quelconque des modes de réalisation sus-présentés. Un tel vibrateur 100 comprend un boîtier 101 dans lequel est fixé le résonateur 102. Le boîtier peut présenter une forme cylindrique ou parallélépipédique, ou encore toutes autres formes compactes susceptibles d'être incorporées en occupant un minimum de volume dans un dispositif électronique portable, tel un téléphone mobile.

Selon l'exemple représenté à la figure 7, le boîtier 101 de forme parallélépipédique comprend une partie principale 103 avec un fond 104 et des côtés et un couvercle 105 avec un rebord qui a été soudé sous vide, par chauffage et par pression, en utilisant un joint de soudure par exemple en alliage eutectique d'or et d'étain, après que le résonateur 102 est été monté dans le boîtier 101.

Ce montage du résonateur se fait en soudant ou en collant avec une colle dure conductrice les plages de connexions, correspondant aux électrodes 19 et 20 (sur la figure 7) de la face arrière sur des plages conductrices correspondantes 106 prévues sur un échelon 107 du fond 104 situé d'un côté de la partie principale du boîtier, ces plages 106 étant reliées d'une façon non représentée sur le dessin à des plages de contact extérieures 108 et 109 disposées sur la face arrière du fond. En effet, grâce aux avantages procurés par l'utilisation d'un trou à la place des encoches, il est prévu possible d'améliorer encore la résistance aux chocs en sélectionnant une fixation rigide, comme par exemple une colle conductrice epoxy, pour fixer le résonateur à son boîtier.

On comprendra que diverses modifications et / ou améliorations évidentes pour l'homme du métier peuvent être apportées aux différentes modes de réalisation de l'invention décrits dans la présente description, notamment en effectuant des combinaisons des avantages présentés dans ces différents modes, sans sortir du cadre de l'invention défini par les revendications annexées.

## Revendications

1. Résonateur (10) piézo-électrique formé par un cristal de quartz, destiné à être conditionné dans un boîtier, comprenant une base (12) formée d'une première zone de fixation (121), d'une deuxième zone centrale (122) de découplage mécanique et d'une troisième zone (123) opposée à la première zone de fixation, troisième zone à partir de laquelle s'étendent au moins deux bras vibrants (13a, 13b), sur chacun desquels au moins une rainure (141a-144a,141b-144b) est formée sur au moins une des faces supérieure ou inférieure des bras, la base étant pourvue d'un trou (15) au travers de la deuxième zone centrale de découplage mécanique, ledit trou présentant une forme polygonale, **caractérisé en ce qu'**au moins deux côtés adjacents du dit trou (15) forment un angle de 60 ou 120° du côté des flancs latéraux de la base (12).

2. Résonateur piézo-électrique selon la revendication 1, **caractérisé en ce que** ladite première zone de fixation de la base est fixée à un boîtier au moyen d'un agent conducteur rigide.

3. Résonateur piézo-électrique selon la revendication 2, **caractérisé en ce que** l'agent conducteur rigide est un agent adhésif ou une soudure.

4. Résonateur piézo-électrique selon lune des revendication 1 à 3, **caractérisé en ce que** ledit trou présente une longueur (L2) comprise entre 33 et 75% de la largeur (I1) de la base.

5. Résonateur piézo-électrique selon l'une des revendications 1 à 3, **caractérisé en ce que** ledit trou présente une longueur comprise entre 39 et 50% de la largeur de la base.

6. Résonateur piézo-électrique selon l'une des revendications 1 à 5, **caractérisé en ce que** ledit trou présente une largeur (l2) comprise entre 10 et 50% de la longueur (L1) de la base.

7. Résonateur piézo-électrique selon l'une des revendications 1 à 5, **caractérisé en ce que** ledit trou présente une largeur comprise entre 15 et 25% de la longueur de la base.

8. Résonateur piézo-électrique selon l'une des revendications précédentes, **caractérisé en ce que** ladite troisième zone de la base présente une largeur (I3) comprise entre 50 et 200% de la largeur (l4) d'un bras.

9. Résonateur piézo-électrique selon l'une des revendications précédentes, **caractérisé en ce que** ladite troisième zone de la base présente une largeur comprise entre 80 et 130% de la largeur d'un bras.

10. Résonateur piézo-électrique selon l'une des revendications précédentes, **caractérisé en ce que** ledit trou présente une forme polygonale dont les côtés sont découpés de manière à minimiser la révélation des plans cristallins du résonateur piézo-électrique.

11. Résonateur piézo-électrique selon l'une des revendications précédentes, **caractérisé en ce** chaque bras comprend deux rainures droites sur chacune des faces inférieure et supérieure.

12. Résonateur piézo-électrique selon la revendication 2 ou 3, **caractérisé en ce que** la troisième zone présente au niveau de la fixation des bras une découpe minimisant la révélation des plans cristallins du résonateur piézo-électrique.

13. Résonateur piézo-électrique selon la revendication 12, **caractérisé en ce que** le résonateur est formé par un cristal de quartz et en ce ladite découpe présente un angle 60 ou 120°.

14. Vibrateur (100) comprenant un boîtier (101) dans lequel est fixé un résonateur (102) piézo-électrique selon la revendication 1, **caractérisé en ce que** un agent conducteur rigide est utilisé comme moyens de fixation entre le boîtier et le résonateur.

15. Résonateur piézo-électrique selon la revendication 1, **caractérisé en ce que** ledit trou présente une forme octogonale présentant quatre angles de 120° du côté des flancs latéraux de la base du résonateur.

16. Résonateur piézo-électrique selon la revendication 1, **caractérisé en ce que** ledit trou présente une forme hexagonale présentant deux angles de 60° du côté de flancs latéraux de la base du résonateur.

17. Résonateur piézo-électrique selon la revendication 1, **caractérisé en ce que** ledit trou présente une forme hexagonale présentant six angles de 120°.

## Claims

1. Piezoelectric resonator (10) made of a quartz crystal, intended to be packaged in a case, including a base (12) formed of a first fixing zone (121), a second central mechanical uncoupling zone (122) and a third zone (123) opposite to the first fixing zone, at least two vibrating arms (13a, 13b) extending from said third zone, on each of which at least one groove (141a-144a, 141b-144b) is formed on at least one of the top or bottom faces of the arms, the base being provided with a hole (15) through the second central mechanical uncoupling zone, said hole having a polygonal shape, **characterised in that** at least two adjoining sides of said hole (15) form a 60° or 120° angle on the side of the lateral flanks of the base (12).

2. Piezoelectric resonator according to claim 1, **characterised in that** said first fixing zone of the base is fixed to a case by means of a rigid conductive agent.

3. Piezoelectric resonator according to claim 2, **characterised in that** the rigid conductive agent is an adhesive agent or a weld.

4. Piezoelectric resonator according to any of claims 1 to 3, **characterised in that** said hole has a length (L2) comprised between 33 and 75% of the width (11) of the base.

5. Piezoelectric resonator according to any of claims 1 to 3, **characterised in that** said hole has a length comprised between 39 and 50% of the width of the base.

6. Piezoelectric resonator according to any of claims 1 to 5, **characterised in that** said hole has a width (12) comprised between 10 and 50% of the length (L1 ) of the base.

7. Piezoelectric resonator according to any of claims 1 to 5, **characterised in that** said hole has a width comprised between 15 and 25% of the length of the base.

8. Piezoelectric resonator according to any of the preceding claims, **characterised in that** said third zone of the base has a width (13) comprised between 50 and 200% of the width (14) of an arm.

9. Piezoelectric resonator according to any of the preceding claims, **characterised in that** said third zone of the base has a width comprised between 80 and 130% of the width of an arm.

10. Piezoelectric resonator according to any of the preceding claims, **characterised in that** said hole has a polygonal shape the sides of which are cut so as to minimise the uncovering of the crystalline planes of the piezoelectric resonator.

11. Piezoelectric resonator according to any of the preceding claims, **characterised in that** each arm includes two straight grooves on each of the bottom and top faces.

12. Piezoelectric resonator according to claim 2 or 3, **characterised in that**, where the arms are fixed, the third zone has a cut out portion minimising the uncovering of the crystalline planes of the piezoelectric resonator.

13. Piezoelectric resonator according to claim 12, **characterised in that** the resonator is formed by a quartz crystal and **in that** said cut out portion has an angle of 60 or 120°.

14. Vibrator (100) including a case (101) in which a piezoelectric resonator according to claim 1, is fixed, **characterised in that** a rigid conductive agent is used as means for fixing the case to the resonator.

15. Piezoelectric resonator according to claim 1, **characterised in that** said hole has an orthogonal shape with four 120° angles on the side of the lateral flanks of the base of the resonator.

16. Piezoelectric resonator according to claim 1, **characterised in that** said hole has an hexagonal shape with two 60° angles on the side of the lateral flanks of the base of the resonator.

17. Piezoelectric resonator according to claim 1, **characterised in that** said hole has an hexagonal shape with six 120° angles.

## Patentansprüche

1. Piezoelektrischer Resonator (10), der durch einen Quarzkristall gebildet ist und dazu bestimmt ist, in ein Gehäuse eingesetzt zu werden, mit einer Basis (12), die aus einer ersten Befestigungszone (121), einer zweiten mittleren Zone (122) zur mechanischen Entkopplung und einer dritten Zone (123) gegenüber der ersten Befestigungszone gebildet ist, wobei sich von der dritten Zone wenigstens zwei Schwingarme (13a, 13b) erstrecken, wobei auf jedem hiervon wenigstens eine Nut (141a-144a, 141b-144b) in der oberen Fläche und/oder in der unteren Fläche der Arme gebildet ist, wobei die Basis mit einem Loch (15) durch die zweite mittlere Zone zur mechanischen Entkopplung versehen ist, wobei das Loch eine Polygonform aufweist, **dadurch gekennzeichnet, dass** wenigstens zwei aneinander grenzende Seiten des Lochs (15) bei den seitlichen Flanken der Basis (12) einen Winkel von 60 oder 120° bilden.

2. Piezoelektrischer Resonator nach Anspruch 1, **dadurch gekennzeichnet, dass** die erste Befestigungszone der Basis an einem Gehäuse mittels eines starren Leitermittels befestigt ist.

3. Piezoelektrischer Resonator nach Anspruch 2, **dadurch gekennzeichnet, dass** das starre Leitermittel ein Klebe- oder Lötmittel ist.

4. Piezoelektrischer Resonator nach einem der Ansprüche 1 bis 3, **dadurch gekennzeichnet, dass** das Loch eine Länge (L2) im Bereich von 33 bis 75 % der Breite (11) der Basis aufweist.

5. Piezoelektrischer Resonator nach einem der Ansprüche 1 bis 3, **dadurch gekennzeichnet, dass** das Loch eine Länge im Bereich von 39 bis 50 % der Breite der Basis aufweist.

6. Piezoelektrischer Resonator nach einem der Ansprüche 1 bis 5, **dadurch gekennzeichnet, dass** das Loch eine Breite (I2) im Bereich von 10 bis 50 % der Länge (L1) der Basis aufweist.

7. Piezoelektrischer Resonator nach einem der Ansprüche 1 bis 5, **dadurch gekennzeichnet, dass** das Loch eine Breite im Bereich von 15 bis 25 % der Länge der Basis aufweist.

8. Piezoelektrischer Resonator nach einem der vorhergehenden Ansprüche, **dadurch gekennzeichnet, dass** die dritte Zone der Basis eine Breite (13) im Bereich von 50 bis 200 % der Breite (14) eines Arms aufweist.

9. Piezoelektrischer Resonator nach einem der vorhergehenden Ansprüche, **dadurch gekennzeichnet, dass** die dritte Zone der Basis eine Breite im Bereich von 80 bis 130 % der Breite eines Arms aufweist.

10. Piezoelektrischer Resonator nach einem der vorhergehenden Ansprüche, **dadurch gekennzeichnet, dass** das Loch eine Polygonform aufweist, deren Seiten abgeschnitten sind, derart, dass die Entwicklung der Kristallebenen des piezoelektrischen Resonators minimal ist.

11. Piezoelektrischer Resonator nach einem der vorhergehenden Ansprüche, **dadurch gekennzeichnet, dass** jeder Arm zwei geradlinige Nuten sowohl auf der unteren als auch auf der oberen Fläche aufweist.

12. Piezoelektrischer Resonator nach Anspruch 2 oder 3, **dadurch gekennzeichnet, dass** die dritte Zone auf Höhe der Befestigung der Arme einen Ausschnitt aufweist, der die Entwicklung der Kristallebenen des piezoelektrischen Resonators minimal macht.

13. Piezoelektrischer Resonator nach Anspruch 12, **dadurch gekennzeichnet, dass** der Resonator aus einem Quarzkristall gebildet ist und dass der Ausschnitt einen Winkel von 60 oder 120° besitzt.

14. Vibrationseinrichtung (100), die ein Gehäuse (101) aufweist, in dem ein piezoelektrischer Resonator (102) nach Anspruch 1 befestigt ist, **dadurch gekennzeichnet, dass** ein starres Leitermittel für die Mittel zum Befestigen zwischen dem Gehäuse und dem Resonator verwendet wird.

15. Piezoelektrischer Resonator nach Anspruch 1, **dadurch gekennzeichnet, dass** das Loch eine achteckige Form aufweist, die bei den seitlichen Flanken der Basis des Resonators vier Winkel von 120° aufweist.

16. Piezoelektrischer Resonator nach Anspruch 1, **dadurch gekennzeichnet, dass** das Loch eine sechseckige Form aufweist, die bei den seitlichen Flanken der Basis des Resonators zwei Winkel von 60° aufweist.

17. Piezoelektrischer Resonator nach Anspruch 1, **dadurch gekennzeichnet, dass** das Loch eine hexagonale Form aufweist, die sechs Winkel von 120° aufweist.
